# EUROPEAN PATENT APPLICATION

(11) **EP 2 853 808 A2**
(43) Date of publication of application: **01.04.2015**
(21) Application number: 14181849.2
(22) Date of filing: 21.08.2014
(51) Int. Cl.: F21V 8/00

(54) **Display device including fluoride phosphor**

(30) Priority: 27.09.2013 KR 20130115194
(71) Applicant: Samsung Electronics Co., Ltd, Gyeonggi-do 443-742 (KR)
(72) Inventor: Lee, Kye Hoon, Gyeonggi-do (KR); Jang, Nae Won, Gyeonggi-do (KR)
(74) Representative: Taor, Simon Edward William

(57) **Abstract**

A display device having a superior color reproduction in the ranges of green and red colors by using a fluoride phosphor is disclosed. The display device includes a light emitting diode (LED) package having a light emitting diode, a wavelength converting member to convert a wavelength of light output from the light emitting diode, and a light guide panel to reflect, refract and scatter the light having a converted wavelength, wherein the wavelength converting member includes a fluoride phosphor and a curing resin.

## Description

Devices according to the exemplary embodiments relate to a display device including a fluoride phosphor.

A Light Emitting Diode (LED) is referred to as a semiconductor device configured to convert electricity into an ultraviolet ray, a visible ray, and an infrared ray by using a characteristic of a compound semiconductor, and is mainly being used in household appliances, remote controllers, and large size electronic displays.

The LED light source having high brightness is being used as a lighting lamp, and as the energy efficiency is high and the replacement cost is low due to a long lifecycle while provided with strength with respect to vibration and impact, and the use of toxic material is not needed, with respect to conservation of energy, protection of the environment, and cost savings, conventional light bulbs and florescent lamps are being replaced.

In addition, the LED may be used as the light source of a mid-to-large size Liquid Crystal Display Television (LCD TV), and in a case when the LED light source is used as a backlight of a LCD, with respect to designing the light source, there have been an increasing number of attempts to expand the color range that may be implemented on a LCD panel.

In the related art, a white LED package (white LED PKG) is composed as a blue LED chip disposed at a lead frame, and after mixing a phosphor, which emits colors in the red and green ranges, with a support material such as silicon, the mixture of the phosphor and the support material is disposed to surround the blue LED chip, or the blue LED chip is disposed at the lead frame and covered with an encapsulation material, and then a phosphor of a single material or an evenly mixed phosphor is coated on the surface of the encapsulation material, at an even thickness.

However, with respect to the technology of the related art, the distinction between the green and red is not certain in terms of optical spectrum distribution, and thus the colors are in a mixed status. Therefore, when the LCD display is implemented, the characteristic in the reproduction of the colors is not superior. To improve the characteristic in the reproduction of the colors at the time of implementing the LCD display, research is currently in progress.

Therefore, it is an aspect of the exemplary embodiments to provide a display device having a superior color reproduction in the ranges of green and red colors by using a fluoride phosphor.

Additional aspects of the exemplary embodiments will be set forth in part in the description which follows and, in part, will be obvious from the description, or may be learned by practice of the exemplary embodiments.

In accordance with one aspect of the exemplary embodiments, a display device includes a light emitting diode package, a wavelength converting member, and a light guide panel. The light emitting diode (LED) package may have a light emitting diode. The wavelength converting member may be configured to convert a wavelength of light output from the light emitting diode. The light guide panel may be configured to reflect, refract and scatter the light having a converted wavelength. The wavelength converting member may include a fluoride phosphor and a curing resin.

The fluoride phosphor may be configured to convert the light being output from the light emitting diode into a red light.

The fluoride phosphor may include a host and an activator.

The host may form a crystal of A2 [MF₇] or A₃ [XF6], the A may be at least one selected from the group consisting of lithium Li, natrium Na, kalium K, rubidium Rb, cesium Cs, and ammoniumNH₄+, the M may be at least one selected from the group consisting of niobium Nb, tantalum T, and silicon Si, and the X may be at least one selected from the group consisting of scandium Sc, a Y Alloy, lanthan La, lanthanide, and bismuth Bi.

The activator may be at least one selected from the group consisting of europium Eu, cerium Ce, manganese Mn, silver Ag, and molybdenum Mo.

The wavelength converting member may be disposed between the light guide panel and the LED package.

The wavelength converting member may further include a sialon phosphor.

The sialon phosphor may be configured to convert the light emitted from the light emitting diode into a green light.

The LED package may further include a lead frame forming an exterior appearance of the LED package, and an encapsulation material disposed to surround the light emitting diode.

The display device may further include a barrier film configured to block penetration of moisture into the wavelength converting member.

The barrier film may include a resin-based flexible layer and a silicon-based moisture blocking layer.

The barrier film may be provided in the shape of a strip having a space at an inside thereof and an opening at a lateral side thereof, so that the wavelength converting member is accommodated in the space.

The display device may further include a sealing member configured to seal the opening.

The display device may further include a cover glass having a groove formed at a central portion thereof, and the wavelength converting member is accommodated in the groove and the cover glass is sealed by the barrier film.

A groove may be formed at the encapsulation material of the LED package, so that the cover glass sealed by the barrier film is coupled to the groove.

An aspect of an exemplary embodiment may provide a display device, the display device including: a wavelength converting member configured to convert a wavelength of light output from a light emitting diode; wherein the wavelength converting member comprises a fluoride phosphor and a curing resin.

The display device may further include a light emitting diode (LED) package having a light emitting diode.

The display apparatus may further include a light guide panel to reflect, refract and scatter the light having a converted wavelength.

The fluoride phosphor may be configured to convert the light being output from the light emitting diode into a red light.

The fluoride phosphor may include a host and an activator, wherein the host forms a crystal of A2 [MF₇] or A₃ [XF6], the A is at least one selected from the group consisting of lithium Li, natrium Na, kalium K, rubidium Rb, cesium Cs, and ammoniumNH₄+, the M is at least one selected from the group consisting of niobium Nb, tantalum T, and silicon Si, and the X is at least one selected from the group consisting of scandium Sc, a Y Alloy, lanthan La, lanthanide, and bismuth Bi.

According to an aspect of the invention, there is provided a display device as set out in claim 1. Preferred features are set out in claims 2 to 15.

These and/or other aspects of the disclosure will become apparent and more readily appreciated from the following description of the exemplary embodiments, taken in conjunction with the accompanying drawings of which:
FIG. 1 is an exploded perspective view of a display device in accordance with an exemplary embodiment.
FIG. 2 is a cross-sectional view taken along line A-A' of FIG. 1. FIG. 3 is a drawing which illustrates a structure of a barrier film in accordance with an exemplary embodiment.
FIG. 4 and FIG. 5 are drawings illustrating a structure of a wavelength converting member accommodated in the barrier film having a strip shape.
FIG. 6 is a drawing illustrating a structure of an opening of the barrier film sealed by a sealing member.
FIG. 7 is a view which illustrates a reliability graph of fluoride phosphor in a case where the structure shown in FIGS. 4 to 6 is used.
FIG. 8 is a drawing which illustrates a structure and light emitting principle of the phosphor.
FIG. 9 is a flow chart which illustrates a process of a white light being formed by the light emitting principle of the phosphor illustrated on FIG. 8.
FIG. 10 is a drawing which illustrates a spectrum of light converted through each process of FIG. 9.
FIG. 11 is a drawing which visually illustrates an improvement of the color reproduction by using the fluoride phosphor, through the CIE 1931 color distribution chart.
FIG. 12 is an exploded perspective view illustrating a display device in accordance with another exemplary embodiment.
FIG. 13 is a cross-sectional view taken along line C-C' of FIG. 12.
FIG. 14 is a flow chart which illustrates a process of white light forming in the LED package illustrated in FIG. 12.
FIG. 15 is a drawing which illustrates a spectrum of a light converted through each process of FIG. 14.

Reference will now be made in detail to the exemplary embodiments, examples of which are illustrated in the accompanying drawings, wherein like reference numerals refer to like elements throughout.

A display device in accordance with one exemplary embodiment includes a light emitting diode (LED) package having a light emitting device, a wavelength converting member configured to convert a wavelength of the light that is output from the light emitting device, and a light guide panel configured to reflect, refract and scatter the light provided with the wavelength converted, and the wavelength converting member includes a fluoride phosphor and a curing resin.

In addition, the fluoride phosphor includes a host and an activator, and converts the light being output from the light emitting device into a red light.

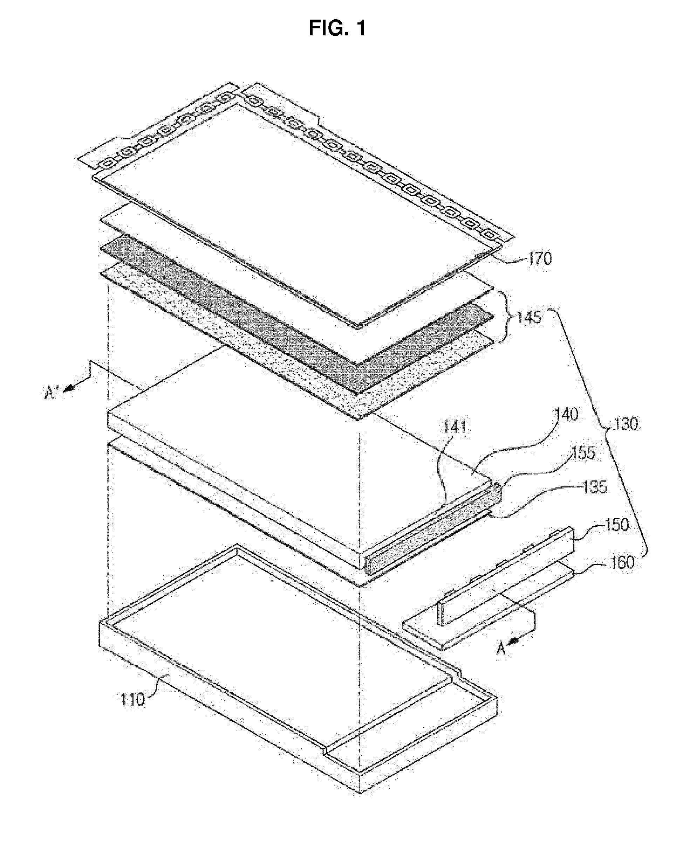

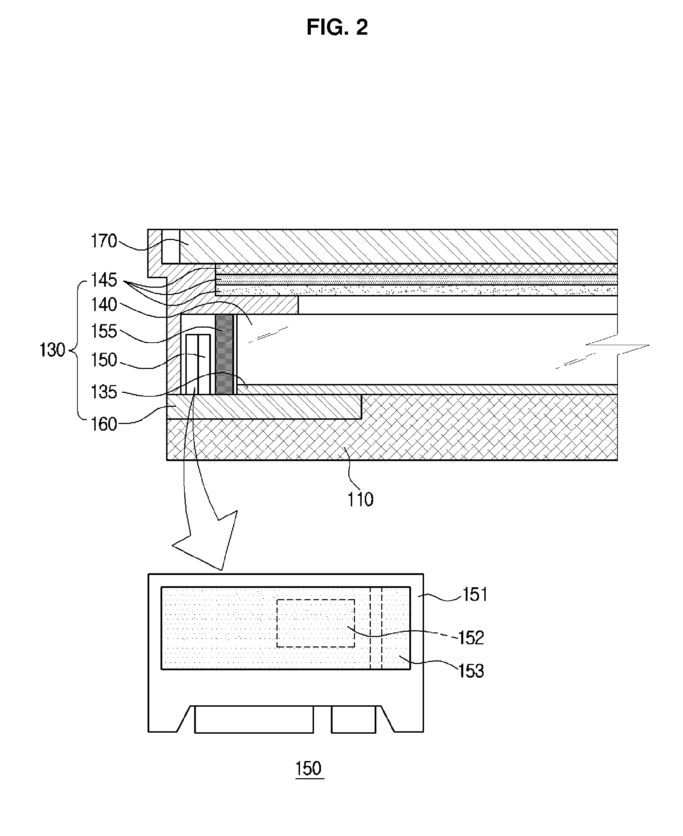

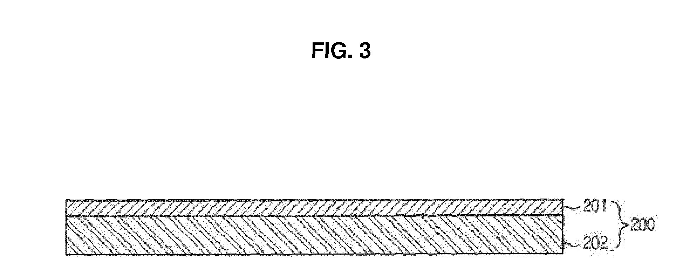

FIG. 1 is an exploded perspective view of a display device in accordance with an exemplary embodiment. FIG. 2 is a cross-sectional view taken along line A-A' of FIG. 1, and FIG. 3 is an enlarged view which illustrates a wavelength converting member 155 provided in the structure of a strip.

Referring to FIG. 1 and FIG. 2, the display device in accordance with an exemplary embodiment includes a mold frame 110, a backlight assembly 130, and a liquid crystal panel 170.

The mold frame 110 is configured to accommodate the backlight assembly 130 and the liquid crystal panel 170. The mold frame 110 is provided in the shape of a rectangular tray, and may be formed using plastic or tempered plastic but embodiments of the invention are not limited thereto.

In addition, at a lower side or a lateral side of the mold frame 110, a sash surrounding the mold frame 110 and supporting the backlight assembly 130 is disposed. The sash is configured to improve the durability and anti-fire characteristic of the mold frame 110.

The backlight assembly 130 is configured to be disposed at an inner side of the mold frame 110 to supply light, and includes a plurality of optical sheets 145 configured to supply the light being output from at least one light source to the liquid crystal panel 170 in an efficient manner, through optical compensation.

In particular, the backlight assembly 130 includes a reflective sheet 135 disposed at a bottom surface at an inner side of the mold frame 110, a light guide panel 140 disposed at an upper portion of the reflective sheet 135, the plurality of optical sheets 145 disposed at an upper portion of the light guide panel 140, a LED package 150 disposed at a side of the light guide panel 140 and provided with a light emitting device 152, a wavelength converting member 155 disposed between the light guide panel 140 and the LED package 150, and a printed circuit board (PCB) 160 at which the LED package 150 is mounted.

The reflective sheet 135 is disposed at a lower side of the light guide panel 140 so as to reflect the light being output from the light emitting device 152 toward the direction of the light guide panel 140. In particular, the reflective sheet 135 is configured to perform a role to cause the light to proceed again toward the light guide panel 140 by reflecting the light refracted toward the lower direction from the light guide panel 140.

The light guide panel 140 is disposed on the reflective sheet 135, and is configured to reflect the light, which is emitted from a light emitting device 152, toward the direction of the optical sheet 145 through reflection, refraction, and scattering after receiving the light emitted from a light emitting device 152, and may include a diffusion substance as to assist the proceeding of the light. In addition, at a rear surface of the light guide panel 140, a predetermined pattern or groove configured to scatter the light being incident may be formed.

The light guide panel 140 includes an incident surface 141 at which the light being output from the light emitting device 152 is incident. That is, one of the side surfaces of the light guide panel 140 facing the light emitting device 152 is referred to as the incident surface 141.

The optical sheet 145 is provided in between the liquid crystal panel 170 and the light guide panel 140, and is configured to perform a role to diffuse and collect the light being guided from the light guide panel 140 to proceed to the liquid crystal panel 170, and may also be composed of at least one diffusion sheet and prism sheet. The diffusion sheet is configured to perform a role to diffuse the light emitted from the light guide panel 140, and the prism sheet is configured to perform a role to collect the diffused light by the diffusion sheet so as to supply the light to the liquid crystal panel 170 in an even manner.

Typically, the diffusion sheet is provided as a single sheet, while the prism sheet is preferred to be provided with a first sheet and a second sheet that respectively have prisms disposed perpendicular to each other in the x-axis and the y-axis, so that light may be refracted from the direction of the x-axis and the y-axis to improve the characteristic of directionality.

The LED package 150 includes a point light source, and is disposed at a side surface of the light guide panel 140. The LED package 150, as such, is embodied with at least one LED semiconductor device and is bonded to the PCB 160. In addition, in FIG. 1 and FIG. 2, an example is illustrated where the LED package 150 is disposed at one side surface of the light guide panel 140, but according to the intention of a designer, even in a case when the LED package 150 is disposed at both side surfaces or at entire side surfaces, the technological aspect of the exemplary embodiments may be applied.

Referring to FIG. 2, the LED package 150 in accordance with an exemplary embodiment includes a lead frame 151 forming an exterior appearance, a light emitting device 152 to generate light, and an encapsulation material 153 disposed to surround the light emitting device 152.

The light emitting device 152 is a light source to generate light, and is configured to output the generated light toward the encapsulation material 153 and the wavelength converting member 155.

The light emitting device 152 may be implemented using a blue light emitting diode to generate blue light, and the blue LED is configured to generate blue light having a wavelength range of about 420 nm and about 500 nm.

The light emitting device 152 is mounted on the PCB 160, and is driven by a driving signal received by the PCB 160.

The encapsulation material 153 is disposed to surround the light emitting device 152, and may be formed of silicon based material. The wavelength converting member 155 may be provided in between the encapsulation material 153.

The wavelength converting member 155 includes a curing resin and a fluoride phosphor mixed with a curing resin. In addition, the wavelength converting member 155 may further include a sialon phosphor.

The wavelength converting member 155 in accordance with an exemplary embodiment is provided in the structure of a strip having a long and thin shape, and is disposed between the light guide panel 140 and the LED package 150. That is, the wavelength converting member 155 is attached to one side surface of the light guide panel 140, and in particular, may be attached to the incident surface 141 of the light guide panel 140. In addition, the wavelength converting member 155 may be attached to and disposed at the LED package 150.

The sialon phosphor forming the wavelength converting member 155 may be included in the encapsulation material 153 of the LED package 150, and in the case of an exemplary embodiment, the sialon phosphor is mixed with the encapsulation material 153 to be included in the LED package.

Hereinafter, the composition and types of the curing resin and the phosphor included in the wavelength converting member 155 will be described in detail.

The curing resin enables the fluoride based phosphor to be evenly distributed and hardened at an inside of the curing resin at the time of forming the wavelength converting member 155, and as for the curing resin, a silicon-based resin may be used.

The sialon phosphor includes silicon (Si), aluminum (Al), oxygen (O), and nitrogen (N), and receives light output from the light emitting device 152 to convert a wavelength of the light. In particular, the sialon phosphor converts the blue light being output from the light emitting device 152 into a green light.

The fluoride phosphor may be expressed through the following Chemical Formula 1 or Chemical Formula 2.

[Chemical Formula 1] A₂[MF₇]:B⁴⁺

[Chemical Formula 2] A₃[XF₆]:B⁴⁺

The left side of the colon is referred to as the host of the fluoride phosphor, and the right side of the colon is referred to as the activator, and with respect to the functions of the Chemical Formulas, will be described in detail in the related sections hereinafter.

The element A composing the host is at least one selected from the group consisting of lithium Li, natrium Na, kalium K, rubidium Rb, cesium Cs, and ammonium NH₄+, the M is at least one selected from the group consisting of niobium Nb, tantalum T, and silicon Si, and the X is at least one selected from the group consisting of scandium Sc, a Y Alloy, lanthan La, lanthanide, and bismuth Bi.

In addition, the activator 'B' is at least one selected from the group consisting of europium Eu, cerium Ce, manganese Mn, silver Ag, and molybdenum Mo, and the type thereof varies.

In an exemplary embodiment, with respect to the phosphor being used at the backlight assembly 130 of the display device, Eu or Mn may be preferred to be used as the activator.

The fluoride phosphor receives the light output from the light emitting device 152 and converts a wavelength of the light. In particular, the fluoride phosphor converts the blue light being output from the light emitting device 152 into a red light.

At this time, the fluoride phosphor of the wavelength converting member 155 is vulnerable to moisture, and thus in a case when the LED package technology of the related art is applied, the functionality as the wavelength converting member 155 is quickly lost.

To prevent this vulnerability, a structure to prevent the penetration of moisture into the wavelength converting member 155 may be applied, and in an exemplary embodiment, the present disclosure adopts a structure having the wavelength converting member 155 accommodated at an inside a barrier film 200 that is provided in the shape of a strip.

Hereinafter, the structure of the barrier film 200 and the form of accommodating the wavelength converting member 155 in the barrier film 200, as well as the application effect of the barrier film 200 will be described in detail.

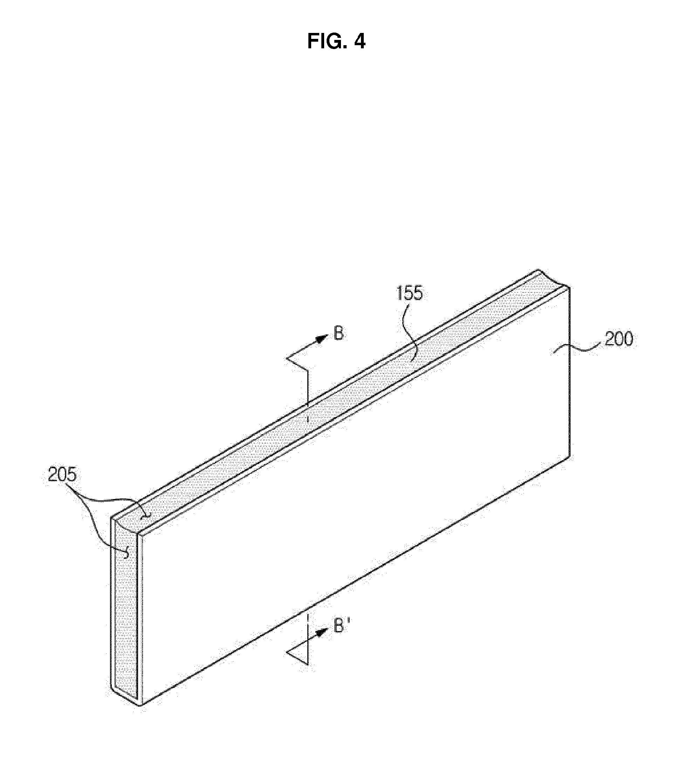

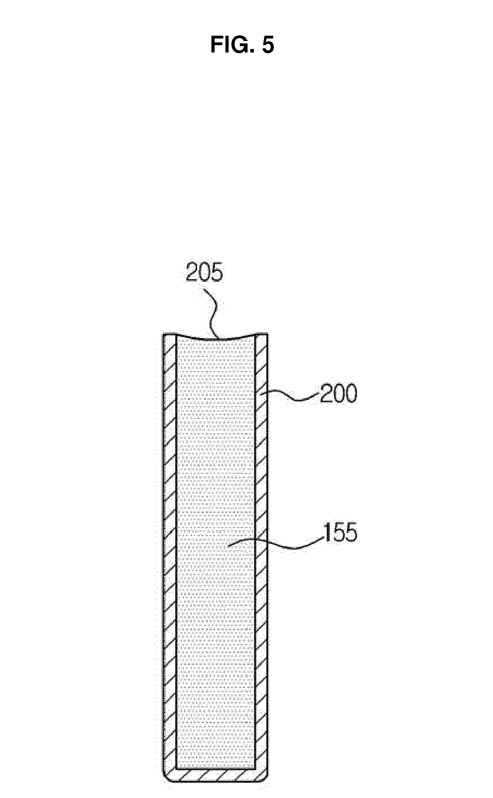

FIG. 3 is a drawing illustrating a structure of the barrier film 200 in accordance with an exemplary embodiment, FIG. 4 and FIG. 5 are drawings which illustrate a structure of the wavelength converting member 155 accommodated at an inside the barrier film 200 having the shape of a strip.

By referring to FIG. 3, the barrier film 200 includes a resin-based flexible layer 202 and a silicon-based moisture blocking layer 201. Through the structure of the barrier film 200 shown on FIG. 3, the barrier film 200 may be provided with the flexible characteristic as well as moisture-blocking characteristic.

Referring to FIG. 4, the barrier film 200 is processed in the shape of a strip provided with an opening 205 each formed at a side surface and an upper surface thereof, and is configured to accommodate the wavelength converting member 155 at a space provided at an inside.

That is, the barrier film 200 serves as a container accommodating the wavelength converting member 155, and in response to the barrier film 200 being cut along line B-B' of FIG. 4, the barrier film 200 is viewed as surrounding the wavelength converting member 155 as shown in FIG. 5.

As shown on FIG. 4, the shape of a strip is referred to a bar structure being extended lengthways in a single direction, and by having the barrier film 200 processed in the shape of a strip, the penetration of moisture into the wavelength converting member 155, particularly into the fluoride phosphor, may be prevented.

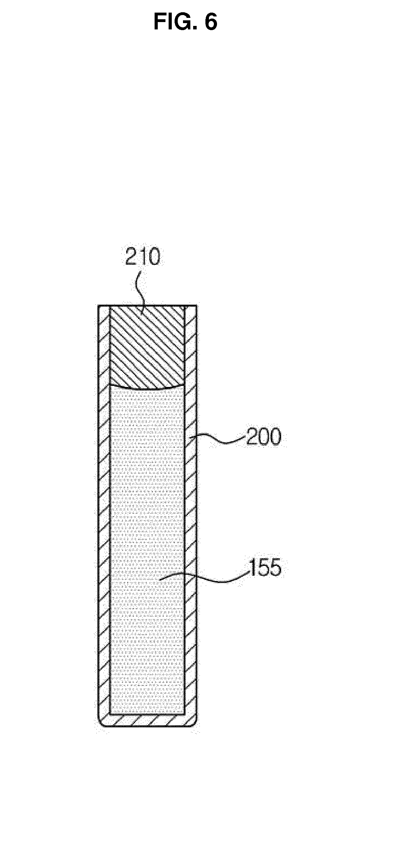

At this time, moisture may penetrate through the opening 205 of the barrier film 200, and as to block the penetration of the moisture through the opening 205 to the wavelength converting member 155; the side surface of the strip structure may be sealed by a sealing member 210, as illustrated on FIG. 6.

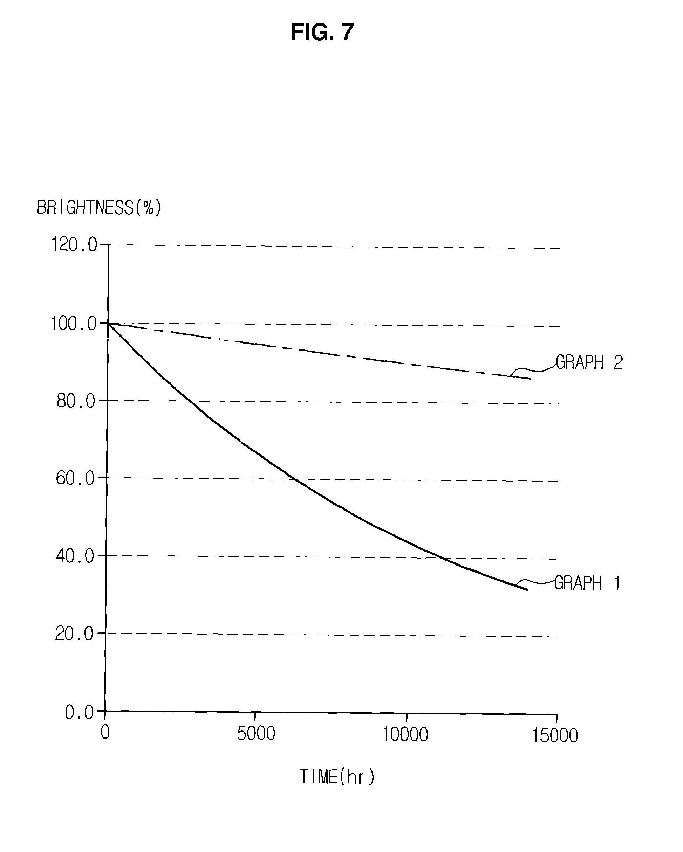

FIG. 7 is a view showing a reliability graph of fluoride phosphor in a case when moisture is blocked by the use of the structures of the FIGS. 4 to 6 from penetrating to the fluoride phosphor, the horizontal axis of the reliability graph is referred to as time, while the vertical axis of the reliability graph is referred to as brightness of the red light converted by the fluoride phosphor.

In addition, graph 1 is referred to as a reliability graph in response to the fluoride phosphor being applied to the structure of the conventional LED package 150, and graph 2 is referred to as a reliability graph when structure of the fluoride phosphor being sealed by the barrier film 200 is applied.

As illustrated on the graph 1, in a case of the conventional LED package 150, moisture is penetrated to the fluoride phosphor, and the brightness of the red light is rapidly decreased as time is passed by.

However, as illustrated on FIG. 2, in a case when the structure of the fluoride phosphor being sealed by the barrier film 200 is applied, the brightness of the red light is relatively maintained in an even manner.

Consequently, the structure of blocking the penetration of moisture to the fluoride phosphor by using the barrier film 200 is preferred.

The liquid crystal panel 170 is disposed at an inner side of the mold frame 110 and on the optical sheets 145 of the backlight assembly 130.

The liquid crystal panel 170 displays an image by adjusting the intensity of the light that is passed therethrough. In particular, the liquid crystal panel 170 displays an image by using the light provided with the wavelength thereof converted by the wavelength converting member 155.

The liquid crystal panel 170 includes a pair of transparent substrates disposed to correspond with each other while having a predetermined gap there between, and a liquid crystal layer sealed in the gap of the pair of transparent substrates.

The first transparent substrate of the pair of transparent substrates is provided at a surface facing the second transparent substrate with a plurality of signal lines extending parallel to each other, a plurality of scanning lines extending while crossing the plurality of signal lines, a plurality of pixel electrodes, formed of transparent conductive films, such as indium tin oxide (ITO), disposed while corresponding to intersections of the signal lines and the scanning lines, and a plurality of thin film transistors (TFTs) disposed while corresponding to the pixel electrodes, respectively. That is, the plurality of pixel electrodes is arranged in the shape of a matrix so that each pixel electrode is disposed at each display pixel.

The second transparent substrate of the pair of transparent substrates is provided at a surface thereof facing the first transparent substrate with a blocking layer having an opening formed at a region approximately corresponding to the pixel electrode, a color filter and an opposed electrode, in a sequential manner.

The blocking layer may be formed of a metallic film or a resin film having a light blocking characteristic, and is formed in a way that each display pixel has the same area of the opening allowing light to pass therethrough. That is, the liquid crystal panel is set in a way that each display pixel has the same opening ratio.

The color filter is composed of a red color filter which corresponds to the red element, a green color filter which corresponds to the green element, and a blue color filter which corresponds to blue element such that a color filter of a corresponding color element is disposed to a display pixel. The color filter is configured to selectively block light or pass light to implement a color.

The opposed electrode is formed of a transparent conductive film, such as ITO, and is formed to set the same level of electric potential at each display pixel.

Hereinafter, the principle of the display device in accordance with an exemplary embodiment forming a white light through the wavelength converting member 155, and the application effect of the fluoride phosphor of the wavelength converting member 155 will be described in detail.

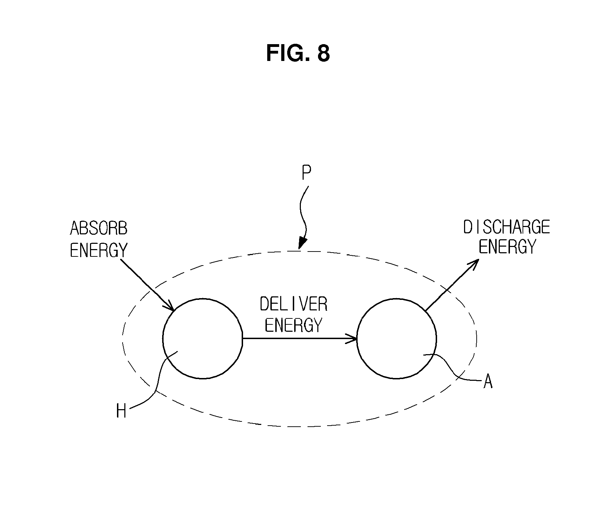

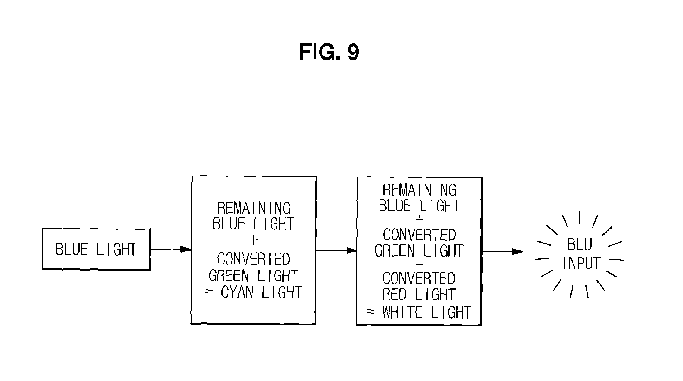

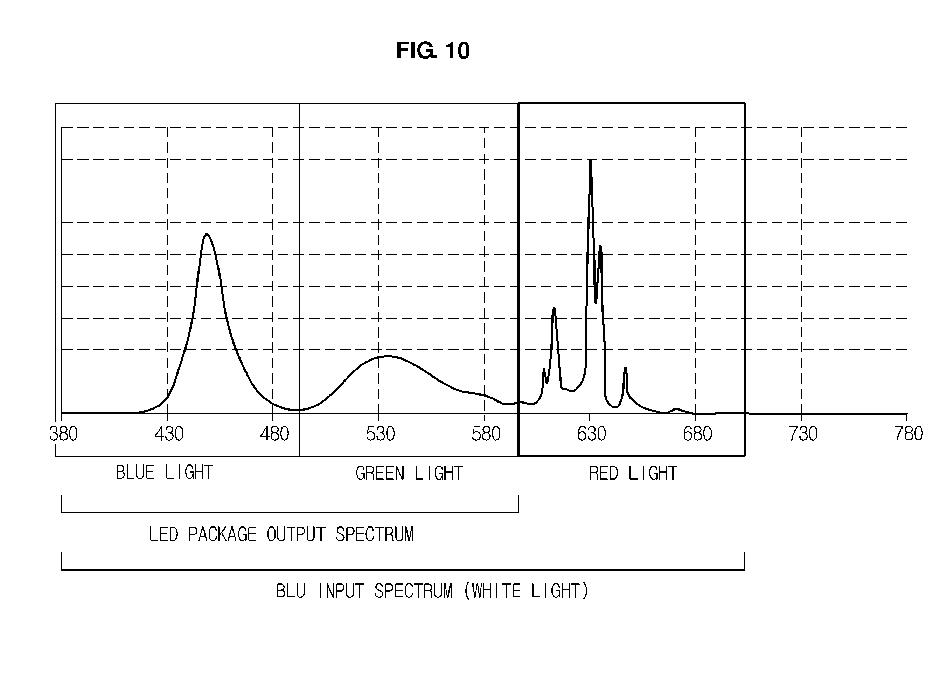

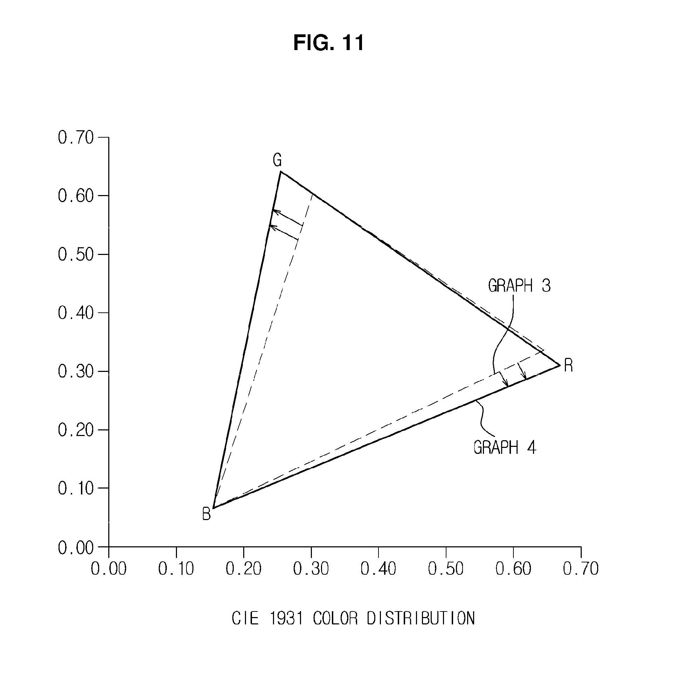

FIG. 8 is a drawing which illustrates the structure and light emitting principle of the phosphor 'P', FIG. 9 is a flow chart which illustrates a process of a white light being formed by the light emitting principle of the phosphor 'P' illustrated on FIG. 8, FIG. 10 is a drawing which illustrates a spectrum of a light converted through each process of FIG. 9, and FIG. 11 is a drawing which visually illustrates an improvement of the color reproduction by using the fluoride phosphor through the CIE 1931 color distribution chart.

Referring to FIG. 8, a phosphor 'P' is a crystalline substance including a host 'H' and an activator `A'. The host `H' is configured to absorb energy from an outside, and thus is needed to be provided with an absorption band at a predetermined range, and in an exemplary embodiment, the host 'H' is provided with a characteristic of effectively absorbing the wavelength of a blue color range. The activator 'A' may be in a positively ionized state as to match the number of electrons required to form a covalence bond with the host `H'. That is, depending on the type of the host `H', the degree of ionization is varied.

In response to the host 'H' absorbing the blue light being output from the light emitting device 152, the absorbed light energy is delivered to the activator 'A' in the electronic form, and at this time, the energy level of the activator 'A' is increased. Then, in the process of the energy level being decreased, the light having an energy corresponding to a band gap is discharged to outside the device, and at this time, the color of the light being discharged is shown in green or red depending on the energy corresponding to the band gap.

With respect to the fluoride phosphor and the sialon phosphor of the Chemical Formula 1 and the Chemical Formula 2 in accordance with an exemplary embodiment as well, the red light and green light are formed by the above principle.

Hereinafter, as an example, by applying the fluoride phosphor to the above principle, the light generated from the LED package 150 while having the wavelength of the blue color range is absorbed to the host 'H' of the fluoride phosphor, the light energy absorbed is delivered to the activator 'A', and thus the energy level of the activator 'A' is increased.

Then, in the process of the energy level being decreased, energy is discharged to outside the device, generating red light.

FIG. 9 is a flow chart which illustrates a process of a white light formed as the green light and the red light, each of which is generated according the principle of FIG. 8, are added. Referring to FIG. 9, the blue light is discharged from the light emitting device 152, a portion of the blue light is converted into the green light by the sialon phosphor, and the converted green light is added to the blue light that remains without being converted, so that a cyan light is formed.

Next, a portion of the remaining blue light is converted into the red light by the fluoride phosphor, and as the converted red light and the cyan light are mixed, a white light is formed.

The white light formed through the process as above is introduced to the light guide panel 140 as an input of the backlight assembly 130 to implement color, and as illustrated by FIG. 10, the spectrum having clear distinction of the green light and the red light may be obtained due to the fluoride phosphor, and thus the reproducing colors is improved.

Referring to (a) of FIG. 10, the blue light in the range of about 400 nm to about 500 nm is discharged at the light emitting device 152, the blue light is converted into the green light in the range of about 500 nm to 590 nm by the sialon phosphor, and converted into the red light in the range of about 590 nm to 780 nm by the fluoride phosphor. With respect to the wavelength converting member 155 of the related art, in a case when the blue light being output from the light emitting device 152 is converted into the green light and the red light by a phosphor 'P', the distinction of the green light and the red light is slight.

However, in the exemplary embodiment, by using the fluoride phosphor, as illustrated on (b) of FIG. 10, the green light and the red light may be clearly distinguished. Furthermore, the characteristic of reproducing colors at the time of implementing the display device may be improved.

In particular, a red filter from among the color filters of the liquid crystal panel 170 allows a red light having a wavelength greater than about 590 nm to pass therethrough while blocking a green light and a blue light having wavelengths that are shorter than 590 nm, and as the peak of a shortwave light is higher as shown in FIG. 10, a red light having higher chroma is being output. By using the same method, the green light having high chroma may be obtained when compared to a method of the related art, and consequently, at the time of implementing the display device, the characteristic in reproducing colors is improved.

Referring to FIG. 11, the characteristic of reproducing color is clearly improved. 'R', 'G', and 'B' of FIG. 11 are referred to red, green, and blue color range, respectively, and in a case when using the fluoride phosphor is used as the wavelength converting member 155, when compared to a case of applying the yellow phosphor 'P' of the related art, a wider color range may be further implemented.

Next, a display device in accordance with another exemplary embodiment will be described in detail.

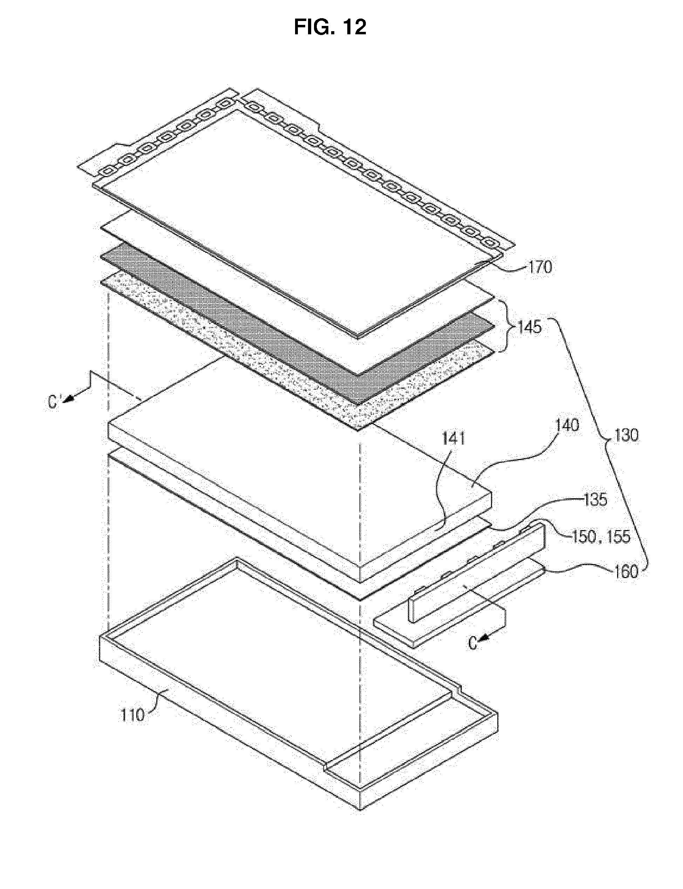

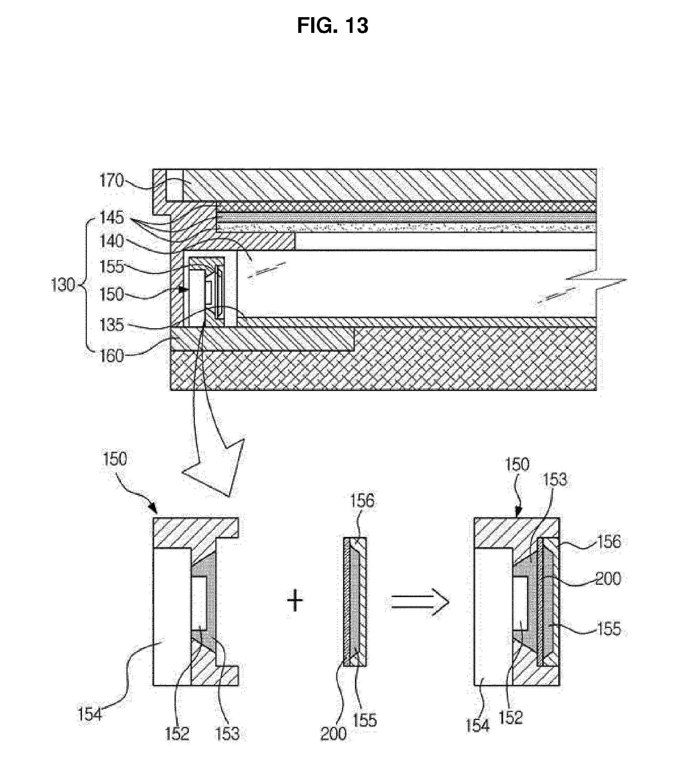

FIG. 12 is an exploded perspective view which illustrates exemplary the display device in accordance with another exemplary embodiment, and FIG. 13 is a cross-sectional view taken along line C-C' of FIG. 12.

Referring to FIG. 12, the display device in accordance with another exemplary embodiment includes a mold frame 110, a backlight assembly 130, and a liquid crystal panel 170, and the mold frame 110 is configured to accommodate the backlight assembly 130 and the liquid crystal panel 170 as previously described. However, the display device in accordance with, this exemplary embodiment is different from the above exemplary embodiment with respect to the disposition of the LED package 150 and the wavelength converting member 155.

Referring to FIG. 13, the LED package 150 includes a lead frame 151 forming an exterior appearance of the LED package 150, a light emitting device 152 to generate light, and an encapsulation material 153 disposed to surround the light emitting device 152, plus a groove (unnumbered) formed at a surface facing the light guide panel 140.

A structure having a barrier film 200 bonded to a cover glass 156 is mounted on the groove formed at the LED package 150. In particular, a groove is formed in the cover glass 156 and the wavelength converting member 155 is accommodated in the groove and sealed by the barrier film 200.

The wavelength converting member 155 includes a curing resin and a fluoride phosphor mixed with a curing resin. In addition, the wavelength converting member 155 may further include a sialon phosphor, and the sialon phosphor may be mixed with a curing resin together with the fluoride phosphor, or may be mixed with the encapsulation material 153 of the LED package 150.

The structure is coupled to the groove of the LED package 150, and is coupled through a curing process.

Hereinafter, by providing an example of the case when the sialon phosphor is mixed with the encapsulation material 153 of the LED package 150, the principle of the display device forming a white light through the wavelength converting member 155 will be described in detail.

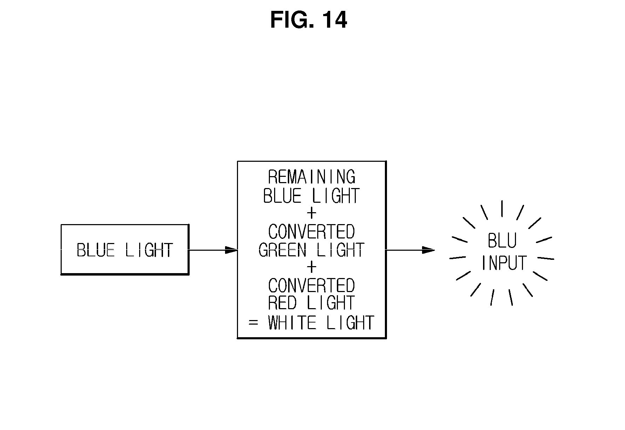

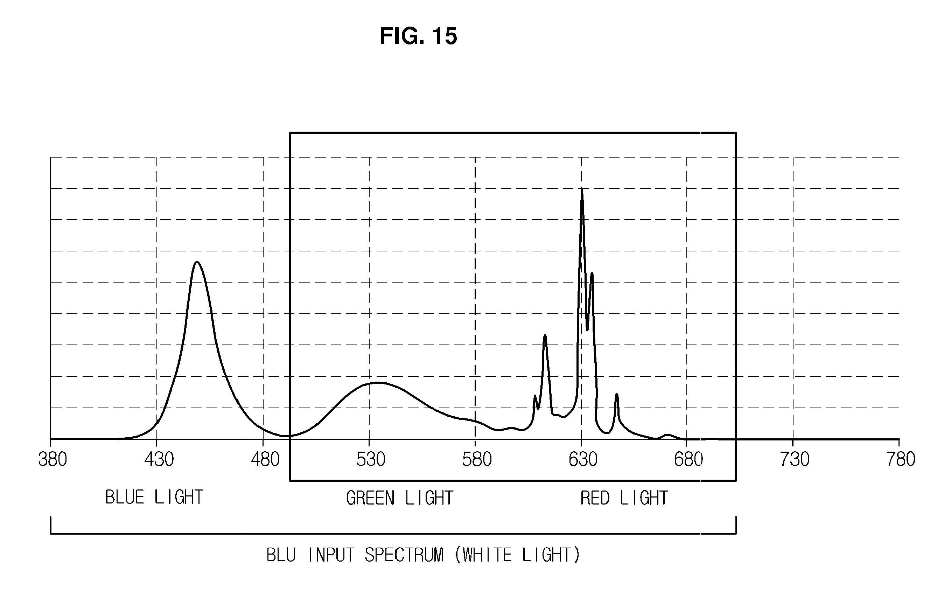

FIG. 14 is a flow chart which illustrates a process of forming a white light, and FIG. 15 is a drawing which illustrates a spectrum of a light converted through each process of FIG. 14.

Referring to FIG. 14, as the blue light is emitted from the light emitting device 152, a portion of the blue light is converted into the green light by the sialon phosphor, and some other portion of the blue light is converted into the red light by the fluoride phosphor.

The remaining blue light and the converted green and red lights are mixed to form a white light, and the white light formed is introduced to the light guide panel 140 as an input of the backlight assembly 130 in order to implement colors.

Referring to FIG. 15, the blue light having the range of about 400 nm to 500 nm is emitted at the light emitting device 152, and the blue light is converted into the green light having the range of about 500 nm to 590 nm by the sialon phosphor, and is converted into the red light having the range of about 590 nm to 780 nm by the fluoride phosphor.

With respect to an exemplary embodiment, the spectrum distinction of the red light and the green light is clear, and accordingly, the characteristic in reproducing colors at the time of implementing the display device may be improved.

As discussed, embodiments of the invention provide a display device, comprising: a light emitting diode (LED) package having a light emitting diode; a wavelength converting member configured to convert a wavelength of light output from the light emitting diode; and a light guide panel arranged to reflect, refract and scatter the light having a converted wavelength, wherein the wavelength converting member comprises a fluoride phosphor and a curing resin.

As is apparent from the above, the colors in the green and red ranges may be effectively reproduced by using a fluoride phosphor as a light converting member.

Although a few exemplary embodiments have been shown and described, it would be appreciated by those skilled in the art that changes may be made in exemplary embodiments without departing from the principles of the disclosure, the scope of which is defined in the claims and their equivalents.

## Claims

1. A display device, comprising:
a light emitting diode (LED) package having a light emitting diode;
a wavelength converting member configured to convert a wavelength of light output from the light emitting diode; and
a light guide panel arranged to reflect, refract and scatter the light having a converted wavelength,
wherein the wavelength converting member comprises a fluoride phosphor and a curing resin.

2. The display device of claim 1, wherein:
the fluoride phosphor is configured to convert the light being output from the light emitting diode into a red light.

3. The display device of claim 1 or 2, wherein:
the fluoride phosphor comprises a host and an activator.

4. The display device of claim 3, wherein:
the host forms a crystal of A2 [MF₇] or A₃ [XF6], the A is at least one selected from the group consisting of lithium Li, natrium Na, kalium K, rubidium Rb, cesium Cs, and ammoniumNH₄+, the M is at least one selected from the group consisting of niobium Nb, tantalum T, and silicon Si, and the X is at least one selected from the group consisting of scandium Sc, a Y Alloy, lanthan La, lanthanide, and bismuth Bi.

5. The display device of claim 3 or 4, wherein:
the activator is at least one selected from the group consisting of europium Eu, cerium Ce, manganese Mn, silver Ag, and molybdenum Mo.

6. The display device of any one of claims 1 to 5, wherein:
the wavelength converting member is disposed between the light guide panel and the LED package.

7. The display device of any one of claims 1 to 6, wherein:
the wavelength converting member further comprises a sialon phosphor.

8. The display device of claim 7, wherein:
the sialon phosphor is configured to convert the light emitted from the light emitting diode into a green light.

9. The display device of any one of claims 1 to 8, wherein:
the LED package further comprises a lead frame forming an exterior appearance of the LED package, and an encapsulation material disposed to surround the light emitting diode.

10. The display device of any one of claims 1 to 9, further comprising:
a barrier film configured to block a penetration of moisture into the wavelength converting member.

11. The display device of claim 10, wherein:
the barrier film comprises a resin-based flexible layer and a silicon-based moisture blocking layer.

12. The display device of claim 10 or 11, wherein:
the barrier film is provided in the shape of a strip having a space at an inside thereof and an opening at a lateral side thereof, so that the wavelength converting member is accommodated within the space.

13. The display device of claim 12, further comprising:
a sealing member configured to seal the opening.

14. The display device of any one of claims 10 to 13, further comprising:
a cover glass having a groove formed at a central portion thereof, and the wavelength converting member is accommodated in the groove and the cover glass is sealed by the barrier film.

15. The display device of claim 14, wherein:
a groove is formed at the encapsulation material of the LED package, so that the cover glass sealed by the barrier film is coupled to the groove.
